# FASCICULE DE BREVET EUROPEEN

(11) **EP 3 836 185 B1**
(45) Date de publication et mention de la délivrance du brevet: **27.09.2023**
(21) Numéro de dépôt: 19214948.2
(22) Date de dépôt: 10.12.2019
(51) Int. Cl.: H01H 33/662, B60L 3/00, H01B 17/00, H01C 7/12, H01T 1/15, H01H 33/56, H01B 17/26

(54) **APPAREIL ÉLECTRIQUE À HAUTE TENSION COMPRENANT UN DISPOSITIF ANTI-EXPLOSION**
HOCHSPANNUNGSELEKTROGERÄT, DAS EINE EXPLOSIONSSCHUTZVORRICHTUNG UMFASST
HIGH VOLTAGE ELECTRICAL APPLIANCE COMPRISING AN ANTI-EXPLOSION DEVICE

(43) Date de publication de la demande: 16.06.2021
(73) Titulaire: Sécheron SA, 1242 Satigny (CH)
(72) Inventeur: Venzin, Nicolas, 74250 Fillinges (FR); Schaerrer, Marc, 1233 Bernex (CH)
(74) Mandataire: Micheli & Cie SA

(56) Documents cités:
- EP-A1- 3 308 174
- JP-A- H01 163 924
- JP-A- H05 101 868
- JP-A- 2002 214 254

## Description

La présente invention concerne un appareil électrique destiné à être connecté à une ligne d'alimentation à haute tension. Par « haute tension » on entend une tension nominale supérieure à 1 kV, de préférence supérieure à 10 kV, typiquement de 12,5 kV (à 60 Hz), de 15 kV (à 16,7 Hz) ou de 25 kV (à 50 ou 60 Hz). La tension peut être alternative ou continue.

La présente invention concerne en particulier un appareil électrique destiné à être placé sur ou dans un véhicule ferroviaire et à être connecté à une ligne d'alimentation à haute tension via un pantographe. L'appareil électrique est par exemple un capteur de courant et/ou de tension, un disjoncteur, un sectionneur, un contacteur ou un parafoudre.

Un appareil électrique de ce type est décrit par exemple dans le brevet EP 3308174. Il comprend un isolateur dans lequel est placé un dispositif électrique, à savoir ici un diviseur de tension résistif, dont la borne supérieure est connectée à la haute tension. L'isolateur comprend un corps creux qui reçoit le dispositif électrique et une enveloppe entourant le corps creux. L'enveloppe définit des ailettes servant à maximiser la ligne de fuite. L'isolateur est monté sur une embase métallique qui renferme des composants électriques à basse tension reliés au dispositif électrique.

Dans un tel appareil, la cavité de l'isolateur qui reçoit le dispositif électrique est remplie d'un matériau isolant sous forme de gel, liquide, gaz ou solide. Lorsque ce matériau isolant et/ou l'isolateur présentent des défauts, ou lorsque la tension reçue excède la tension maximale qu'ils peuvent supporter, un arc électrique peut se former à l'intérieur de l'appareil, brûlant ou vaporisant les matériaux sur son passage. Ceci produit des gaz qui sont chauffés par l'arc et qui provoquent une montée de pression extrêmement rapide dans l'isolateur, pouvant amener l'isolateur à exploser et à blesser des personnes par projection de lourds fragments.

Les brevets US 2529135 et US 2703390 décrivent des appareils électriques à haute tension comprenant des diaphragmes qui se rompent en cas de surpression dans l'appareil afin de permettre aux gaz de sortir et éviter ainsi l'explosion. Dans le brevet US 2529135, les diaphragmes sont situés au niveau de la borne à haute tension, au-dessus de l'isolateur, et sur un boîtier à basse tension situé sous l'isolateur. Dans le brevet US 2703390, ils sont disposés sur le boîtier à basse tension. Un inconvénient de tels diaphragmes est qu'ils peuvent se détériorer sous l'effet des conditions extérieures, en particulier de l'humidité et des polluants, ou même recevoir des chocs. Dans les deux cas, ils risquent de se percer ou de s'ouvrir pendant le fonctionnement normal de l'appareil et de laisser entrer dans ce dernier de l'humidité et des impuretés susceptibles de dégrader son fonctionnement. D'autres documents, JP 2002-214254A, JP H05-101868A et JP H01-163924A, décrivent des parafoudres comprenant un dispositif de sécurité agencé pour évacuer des surpressions de gaz.

La présente invention vise à remédier à l'inconvénient précité ou au moins à l'atténuer et propose à cette fin un appareil électrique selon la revendication 1, des modes de réalisation particuliers étant définis dans les revendications dépendantes.

D'autres caractéristiques et avantages de la présente invention apparaîtront à la lecture de la description détaillée suivante faite en référence aux dessins annexés dans lesquels :
- la figure 1 est une vue en coupe d'un capteur (mesureur) de tension constituant un appareil électrique selon un premier exemple de réalisation de l'invention ;
- la figure 2 est une vue en perspective d'une bague de sécurité faisant partie de l'appareil électrique selon l'invention ;
- la figure 3 est une vue en coupe d'un disjoncteur constituant un appareil électrique selon un deuxième exemple de réalisation de l'invention.

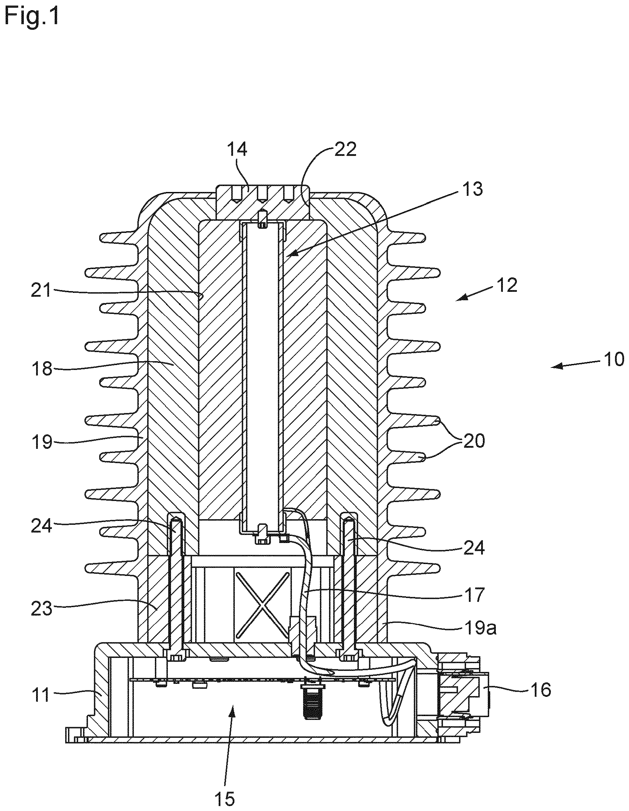

En référence à la figure 1, un appareil électrique 10 selon l'invention comprend une embase conductrice 11, un isolateur 12 monté sur l'embase conductrice 11 et un dispositif électrique 13 monté dans l'isolateur 12.

Le dispositif électrique 13 est connecté en partie supérieure de l'appareil 10 à une borne à haute tension 14.

L'embase conductrice 11, typiquement métallique, est reliée à la terre et renferme un circuit imprimé 15 comprenant des composants à basse tension tels que composants à semi-conducteurs, condensateurs, résistances, amplificateurs opérationnels, transformateurs, etc. permettant de traiter les signaux reçus du dispositif électrique 13. Un connecteur à basse tension 16 sur l'embase conductrice 11 permet de connecter l'appareil 10 à un système électrique à basse tension.

Dans une application typique de l'invention, l'appareil électrique 10 est monté sur ou dans un véhicule ferroviaire, par exemple sur son toit, la borne à haute tension 14 est connectée par l'intermédiaire notamment d'un pantographe à une caténaire et le connecteur à basse tension 16 est relié au reste du système à basse tension du véhicule.

Dans l'exemple représenté à la figure 1, l'appareil électrique 10 est un capteur de tension et le dispositif électrique 13 est une résistance à haute tension faisant partie d'un diviseur de tension résistif dont la résistance à basse tension est sur le circuit imprimé 15 et reliée à la résistance à haute tension par un câble 17 passant de l'intérieur de l'embase conductrice 11 à l'intérieur de l'isolateur 12. Dans une variante, la résistance à basse tension pourrait être située dans l'isolateur 12.

L'isolateur 12 comprend un corps creux 18 et une enveloppe 19 recouvrant le corps creux 18. Le corps creux 18 est en un matériau électriquement isolant et rigide, par exemple en résine époxy (polymère époxyde) qui est aussi un matériau fragile (matériau ne se déformant pas plastiquement). Le corps creux 18 confère la tenue mécanique à l'isolateur 12 et au dispositif électrique 13. L'enveloppe 19 est en un matériau électriquement isolant et souple tel qu'un élastomère, typiquement un élastomère silicone. Ce type de matériau présente de bonnes caractéristiques de résistance au cheminement électrique ainsi que des propriétés auto-nettoyantes et hydrophobes qui consolident le caractère isolant de l'isolateur 12. De préférence, le matériau de l'enveloppe 19 présente une tolérance à l'élongation d'au moins 5%. L'enveloppe 19 définit de manière classique des ailettes 20.

Le dispositif électrique 13 est monté dans la cavité, 21, du corps creux 18 en étant fixé, par exemple par vissage comme représenté, à la borne à haute tension 14 elle-même maintenue dans un trou traversant 22 de la partie supérieure de l'isolateur 12.

La cavité 21 du corps creux 18, autour du dispositif électrique 13, est remplie totalement ou partiellement d'un matériau électriquement isolant sous la forme d'une résine, d'un gel, d'un liquide ou d'un gaz, de préférence d'un gel silicone.

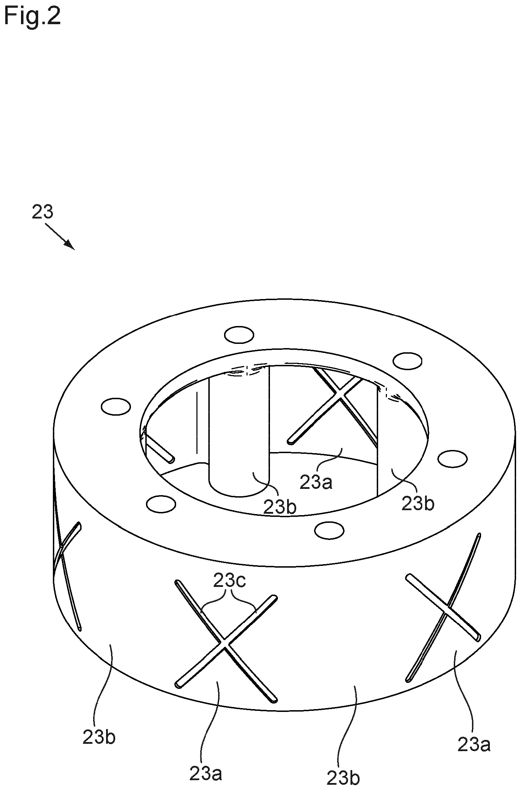

Conformément à l'invention, une bague de sécurité 23, typiquement métallique, est montée coaxialement à l'isolateur 12 à l'intérieur d'une partie 19a de l'enveloppe 19 qui dépasse du corps creux 18 et de préférence aussi du dispositif électrique 13. La bague de sécurité 23 est située axialement entre le corps creux 18 et l'embase conductrice 11 et assure le maintien de l'enveloppe 19, 19a dans le prolongement du corps creux 18. La bague de sécurité 23 est fixée par exemple par des vis 24 vissées dans le corps creux 18 et dont la tête s'appuie contre la paroi intérieure de l'embase conductrice 11. Sa paroi latérale comprend une alternance de parties minces 23a et de parties renforcées 23b (cf. figure 2). Les parties renforcées 23b sont traversées par les vis 24. Les parties minces 23a sont affaiblies par une réduction localisée d'épaisseur définissant des éléments de rupture capables de se rompre en cas de surpression de gaz à l'intérieur de l'isolateur 12 causée par un arc électrique. Dans l'exemple illustré, l'affaiblissement est réalisé par des rainures 23c, formant par exemple des croix comme représenté, usinées sur la surface extérieure et/ou la surface intérieure de la paroi latérale, le fond de ces rainures 23c constituant les éléments de rupture.

Lorsque les éléments de rupture se rompent sous l'effet d'une surpression, la paroi latérale 23a, 23b s'ouvre dans les zones des rainures 23c et les zones de l'enveloppe 19, 19a situées en regard des zones des rainures 23c se déchirent, permettant aux gaz produits par l'arc électrique de s'échapper et évitant ainsi une explosion incontrôlée de l'isolateur 12. Si des fragments de l'enveloppe 19 sont projetés pendant l'évacuation des gaz, ils sont nécessairement petits et, du fait du matériau employé pour réaliser l'enveloppe 19, nécessairement légers, ce qui minimise le risque de blessure de personnes.

En pratique, l'enveloppe 19 peut être surmoulée autour du corps creux 18, de la bague de sécurité 23 et de la borne à haute tension 14. Dans sa partie supérieure, le corps creux 18 peut être surmoulé autour de la borne à haute tension 14. On pourrait en variante réaliser l'enveloppe 19 dans un matériau thermo-rétractable, l'enfiler sur l'ensemble 14, 18, 23 puis la thermo-rétracter. Dans une autre variante, l'enveloppe 19 pourrait être maintenue autour de l'ensemble 14, 18, 23 par son élasticité.

De préférence, sur sa partie 19a qui dépasse du corps creux 18, l'enveloppe 19 ne comporte pas ou peu d'ailettes 20, comme cela est visible sur le dessin.

De préférence également, comme illustré, la bague de sécurité 23 est en contact électrique avec l'embase conductrice 11 reliée à la terre et a donc un potentiel nul. Elle pourrait néanmoins être isolée par rapport à l'embase conductrice 11 et avoir un potentiel différent.

Placer la bague de sécurité 23 à l'intérieur de l'enveloppe 19 comme le propose l'invention protège les parties minces 23a de la corrosion, des chocs et de toute sorte d'autres agressions extérieures qui pourraient percer les éléments de rupture constitués par le fond des rainures 23c et permettre à l'humidité et aux impuretés de pénétrer dans l'appareil 10 et de l'endommager.

De plus, la présence de la bague de sécurité 23 n'augmente pas forcément la taille de l'appareil 10 puisque dans un tel appareil électrique les contraintes dimensionnelles sont à l'extérieur (distance minimale entre le haut et le bas de l'isolateur 12 et cheminement minimal sur la surface extérieure de l'isolateur 12 afin de garantir une bonne isolation), le dispositif électrique 13 à l'intérieur n'ayant pas besoin d'avoir une grande taille pour remplir la fonction qu'on lui demande.

On notera également que la bague de sécurité 23 permet d'éviter de faire transiter le plasma et les gaz brûlants dans la partie électronique à basse tension de l'appareil 10.

De surcroît, la bague de sécurité 23 offre une grande surface pouvant présenter de grandes zones de rupture qui évacueront rapidement toute surpression.

La borne à haute tension 14 peut aussi servir de soupape de sécurité, en étant éjectée par les gaz produits par l'arc électrique et retenue par les câbles et/ou barres de liaison électrique situés au-dessus de l'appareil 10.

En plus de la bague de sécurité 23 et de la soupape de sécurité constituée par la borne à haute tension 14, l'appareil électrique 10 peut comprendre une couche de fibres entre le corps creux 18 et l'enveloppe 19 pour retenir d'éventuels fragments du corps creux 18 qui seraient détachés par un arc électrique passant dans le matériau du corps creux 18. Les fibres peuvent être synthétiques, par exemple en aramide ou para-aramide, ou minérales, par exemple en basalte.

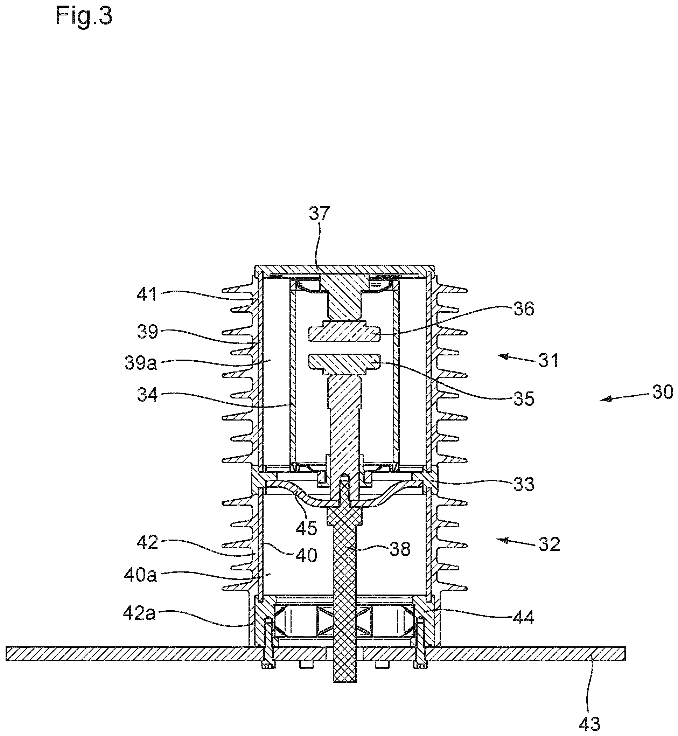

La figure 3 montre un autre exemple d'appareil électrique selon l'invention. L'appareil illustré à la figure 3, désigné par le repère 30, est un disjoncteur destiné typiquement à être monté sur ou dans un véhicule ferroviaire, plus particulièrement sur son toit. Il comprend une partie supérieure d'isolateur 31 et une partie inférieure d'isolateur 32 séparées par une plaque conductrice 33. La plaque conductrice 33, typiquement métallique, est évidée pour permettre à l'intérieur de la partie supérieure d'isolateur 31 et à l'intérieur de la partie inférieure d'isolateur 32 de communiquer. A l'intérieur de la partie supérieure d'isolateur 31 se trouve une bouteille à vide 34 renfermant le contact mobile 35 et le contact fixe 36 du disjoncteur. Le contact mobile 35 est relié électriquement, par exemple par une tresse 45, à la plaque conductrice 33 pour former un premier pôle électrique. Le contact fixe 36 est relié électriquement et mécaniquement à une plaque conductrice supérieure 37 qui ferme l'isolateur 31, 32 pour former un deuxième pôle électrique. A travers la partie inférieure d'isolateur 32 s'étend une tige de commande 38 en matériau isolant solidaire du contact mobile 35.

Chaque partie, supérieure 31 et inférieure 32, de l'isolateur comprend un corps creux 39, 40 en un matériau isolant rigide tel qu'un matériau composite en fibres de verre et résine époxy, qui est aussi un matériau fragile. Chaque partie, supérieure 31 et inférieure 32, de l'isolateur comprend en outre une enveloppe 41, 42 en un matériau isolant souple tel qu'un élastomère, typiquement un élastomère silicone, entourant le corps creux 39, 40.

La cavité 39a, 40a de chaque corps creux 39, 40, autour respectivement de la bouteille à vide 34 et de la tige de commande 38, est remplie d'air. Elle pourrait néanmoins être remplie d'un autre matériau isolant sous forme d'une résine, d'un gel, d'un liquide ou d'un gaz.

L'isolateur 31, 32 est supporté par une plaque de support conductrice 43, typiquement métallique, qui sépare les parties à haute tension et à basse tension de l'appareil 30 et qui est typiquement reliée à la terre.

Une partie 42a de l'enveloppe 42 qui dépasse du corps creux 40 entoure une bague de sécurité 44 située axialement entre le corps creux 40 et la plaque de support conductrice 43. La bague de sécurité 44 est similaire à la bague 23 du premier exemple de réalisation et remplit la même fonction.

Au lieu d'être en deux parties, l'isolateur 31, 32 pourrait être en une seule partie, surmoulée autour de la plaque conductrice 33.

La présente invention n'est pas limitée aux exemples de réalisation décrits ci-dessus. Il va de soi que des modifications pourraient être faites sans sortir du cadre de l'invention revendiquée. En particulier :
- la bague de sécurité 23, 44 pourrait être placée dans une autre partie de l'isolateur 12, 31-32, par exemple dans sa partie supérieure ;
- dans l'exemple des figures 1 et 2, la bague de sécurité 23 pourrait ne pas avoir les parties renforcées 23b, pour augmenter la surface disponible pour les éléments de rupture, et pourrait être positionnée radialement par une coopération de type rainures-nervures avec le corps creux 18 et l'embase conductrice 11 et maintenue axialement par le serrage entre le corps creux 18 et l'embase conductrice 11 réalisé par les vis 24 ;
- la bague de sécurité 23, 44 pourrait être fixée par d'autres moyens que des vis ;
- plusieurs bagues de sécurité pourraient être prévues ;
- même si l'emploi d'éléments de rupture est préféré pour garantir la tenue mécanique de l'isolateur en usage normal, ces éléments de rupture pourraient être remplacés par des ouvertures pratiquées dans la bague de sécurité 23, 44 ;
- la bague de sécurité 23, 44 peut être circulaire ou non circulaire, notamment en fonction de la forme de l'isolateur 12, 31-32 ;
- malgré le caractère avantageux de la bague de sécurité métallique 23, 44, facile à usiner, on pourrait remplacer cette bague par des ouvertures pratiquées dans le corps creux 18, 39-40 de l'isolateur, ouvertures qui constitueraient le dispositif de sécurité selon l'invention ;
- le corps creux 18, 39-40 pourrait être une résine ou autre matériau isolant solide surmoulé autour du dispositif électrique 13, 34.

## Revendications

1. Appareil électrique destiné à être connecté à une haute tension comprenant un isolateur (12 ; 31, 32) et un dispositif électrique (13 ; 34) isolé par l'isolateur (12 ; 31, 32), l'isolateur (12 ; 31, 32) comprenant un corps creux (18 ; 39, 40) dans lequel est situé le dispositif électrique (13 ; 34) et une enveloppe (19 ; 41, 42) qui couvre le corps creux (18 ; 39, 40), **caractérisé en ce que** l'enveloppe (19 ; 41, 42) est réalisée dans un matériau plus souple que celui du corps creux (18 ; 39, 40), et **en ce qu'**un dispositif de sécurité (23 ; 44) pour évacuer une surpression de gaz hors de l'appareil lors de la formation d'un arc électrique est situé dans l'isolateur (12 ; 31, 32) en regard de l'enveloppe (19 ; 41, 42) et est agencé pour permettre à la surpression de gaz d'ouvrir de manière localisée l'enveloppe (19 ; 41, 42).

2. Appareil électrique selon la revendication 1, **caractérisé en ce que** le dispositif de sécurité (23 ; 44) est sous la forme d'une bague.

3. Appareil électrique selon la revendication 1 ou 2, **caractérisé en ce que** le dispositif de sécurité (23 ; 44) comprend un ou plusieurs éléments de rupture.

4. Appareil électrique selon la revendication 3, **caractérisé en ce que** le ou les éléments de rupture comprennent le fond d'une ou plusieurs rainures (23c).

5. Appareil électrique selon l'une quelconque des revendications 1 à 4, **caractérisé en ce que** le dispositif de sécurité (23 ; 44) est métallique.

6. Appareil électrique selon l'une quelconque des revendications 1 à 5, **caractérisé en ce que** le corps creux (18 ; 39, 40) est en un matériau comprenant de la résine époxy.

7. Appareil électrique selon l'une quelconque des revendications 1 à 6, **caractérisé en ce que** le corps creux (18 ; 39, 40) est en un matériau fragile.

8. Appareil électrique selon l'une quelconque des revendications 1 à 7, **caractérisé en ce que** l'enveloppe (19; 41, 42) est en élastomère, de préférence en élastomère silicone.

9. Appareil électrique selon l'une quelconque des revendications 1 à 8, **caractérisé en ce que** l'isolateur (12 ; 31, 32) est monté sur un support conducteur (11 ; 43) séparant le dispositif électrique (13 ; 34) d'une partie électronique à basse tension (15).

10. Appareil électrique selon la revendication 9, **caractérisé en ce que** le dispositif de sécurité (23 ; 44) est placé entre le support conducteur (11 ; 43) et le corps creux (18 ; 39, 40).

11. Appareil électrique selon l'une quelconque des revendications 1 à 10, **caractérisé en ce qu'**il est un capteur de tension (10) et/ou de courant, un disjoncteur (30), un sectionneur, un contacteur ou un parafoudre.

12. Utilisation de l'appareil électrique selon l'une quelconque des revendications 1 à 11 dans le domaine ferroviaire.

## Patentansprüche

1. Elektrogerät, das dazu bestimmt ist, mit einer Hochspannung verbunden zu werden und einen Isolator (12; 31, 32) und eine durch den Isolator (12; 31, 32) isolierte elektrische Vorrichtung (13; 34) umfasst, wobei der Isolator (12; 31; 32) einen hohlen Körper (18; 39, 40), in dem sich die elektrische Vorrichtung (13; 34) befindet, und eine Hülle (19; 41, 42) umfasst, die den hohlen Körper (18; 39, 40) bedeckt, **dadurch gekennzeichnet, dass** die Hülle (19; 41, 42) aus einem biegsameren Material besteht als der hohle Körper (18; 39, 40), und dadurch, dass eine Sicherheitsvorrichtung (23; 44) zum Ablassen eines Überdrucks von Gas aus dem Gerät bei der Bildung eines Lichtbogens sich in dem Isolator (12; 31, 32) gegenüber der Hülle (19; 41, 42) befindet und dazu gestaltet ist, es dem Gasüberdruck zu ermöglichen, die Hülle (19; 41, 42) auf örtlich begrenzte Weise zu öffnen.

2. Elektrogerät nach Anspruch 1, **dadurch gekennzeichnet, dass** die Sicherheitsvorrichtung (23; 44) die Form eines Rings aufweist.

3. Elektrogerät nach Anspruch 1 oder 2, **dadurch gekennzeichnet, dass** die Sicherheitsvorrichtung (23; 44) ein oder mehrere Bruchelemente umfasst.

4. Elektrogerät nach Anspruch 3, **dadurch gekennzeichnet, dass** das oder die Bruchelemente den Boden von einer oder mehreren Rillen (23c) umfassen.

5. Elektrogerät nach einem der Ansprüche 1 bis 4, **dadurch gekennzeichnet, dass** die Sicherheitsvorrichtung (23; 44) metallisch ist.

6. Elektrogerät nach einem der Ansprüche 1 bis 5, **dadurch gekennzeichnet, dass** der hohle Körper (18; 39, 40) aus einem Material besteht, das Epoxidharz umfasst.

7. Elektrogerät nach einem der Ansprüche 1 bis 6, **dadurch gekennzeichnet, dass** der hohle Körper (18; 39, 40) aus einem zerbrechlichen Material besteht.

8. Elektrogerät nach einem der Ansprüche 1 bis 7, **dadurch gekennzeichnet, dass** die Hülle (19; 41, 42) aus Elastomer, vorzugsweise aus Silikonelastomer, besteht.

9. Elektrogerät nach einem der Ansprüche 1 bis 8, **dadurch gekennzeichnet, dass** der Isolator (12; 31, 32) an einem leitfähigen Träger (11; 43) montiert ist, der die elektrische Vorrichtung (13; 34) von einem elektronischen Niederspannungsteil (15) trennt.

10. Elektrogerät nach Anspruch 9, **dadurch gekennzeichnet, dass** die Sicherheitsvorrichtung (23; 44) zwischen dem leitfähigen Träger (11; 43) und dem hohlen Körper (18; 39, 40) platziert ist.

11. Elektrogerät nach einem der Ansprüche 1 bis 10, **dadurch gekennzeichnet, dass** es ein Spannungs- und/oder Stromsensor (10), ein Leistungsschalter (30), ein Trennschalter, ein Schütz oder ein Blitzableiter ist.

12. Verwendung eines Elektrogeräts nach einem der Ansprüche 1 bis 11 auf dem Eisenbahngebiet.

## Claims

1. Electrical apparatus intended to be connected to a high voltage comprising an insulator (12; 31, 32) and an electrical device (13; 34) insulated by the insulator (12; 31, 32), the insulator (12; 31, 32) comprising a hollow body (18; 39, 40) in which there is located the electrical device (13; 34) and a bushing (19; 41, 42) which covers the hollow body (18; 39, 40), **characterised in that** the bushing (19; 41, 42) is produced from a material which is more flexible than that of the hollow body (18; 39, 40), and **in that** a safety device (23; 44) for venting a gas overpressure out of the apparatus during formation of an electric arc is located in the insulator (12; 31, 32) facing the bushing (19; 41, 42) and is arranged to allow the gas overpressure to open the bushing (19; 41, 42) in a localised manner.

2. Electrical apparatus as claimed in claim 1, **characterised in that** the safety device (23; 44) is in the form of a ring.

3. Electrical apparatus as claimed in claim 1 or 2, **characterised in that** the safety device (23; 44) comprises one or more break elements.

4. Electrical apparatus as claimed in claim 3, **characterised in that** the break element(s) comprise the base of one or more grooves (23c).

5. Electrical apparatus as claimed in any one of claims 1 to 4, **characterised in that** the safety device (23; 44) is made of metal.

6. Electrical apparatus as claimed in any one of claims 1 to 5, **characterised in that** the hollow body (18; 39, 40) is made of a material comprising epoxy resin.

7. Electrical apparatus as claimed in any one of claims 1 to 6, **characterised in that** the hollow body (18; 39, 40) is made of a fragile material.

8. Electrical apparatus as claimed in any one of claims 1 to 7, **characterised in that** the bushing (19; 41, 42) is made of elastomer, preferably silicone elastomer.

9. Electrical apparatus as claimed in any one of claims 1 to 8, **characterised in that** the insulator (12; 31, 32) is mounted on a conductive support (11; 43) separating the electrical device (13; 34) from a low-voltage electronic part (15).

10. Electrical apparatus as claimed in claim 9, **characterised in that** the safety device (23; 44) is placed between the conductive support (11; 43) and the hollow body (18; 39, 40).

11. Electrical apparatus as claimed in any one of claims 1 to 10, **characterised in that** it is a current and/or voltage sensor (10), a circuit breaker (30), a disconnector, a contactor or a lightning arrestor.

12. Use of the electrical apparatus as claimed in any one of claims 1 to 11 in the rail industry.
